# EUROPÄISCHE PATENTSCHRIFT

(11) **EP 2 180 499 B1**
(45) Veröffentlichungstag und Bekanntmachung des Hinweises auf die Patenterteilung: **08.05.2013**
(21) Anmeldenummer: 09013461.0
(22) Anmeldetag: 26.10.2009
(51) Int. Cl.: H01J 37/32

(54) **Verfahren zum substratschonenden Entfernen von Hartstoffschichten**
Method for substrate-protecting removal of hard coatings
Procédé de suppression de couches de matière solide préservant le substrat

(30) Priorität: 25.10.2008 DE 102008053254
(43) Veröffentlichungstag der Anmeldung: 28.04.2010
(73) Patentinhaber: EITEC Gesellschaft für metallisches Hartstoffbeschichten GmbH & Co. KG, 44894 Bochum (DE); Hüser, Michael Hermann, 45289 Essen (DE)
(72) Erfinder: Thöne, Karl Stefan, 46414 Rhede (DE); Hüser, Michael Hermann, 45289 Essen (DE)
(74) Vertreter: Thiel, Christian

(56) Entgegenhaltungen:
- EP-A1- 0 496 564
- JP-A- 2003 068 720
- US-A- 5 303 139
- US-A- 5 344 526
- US-A- 5 993 680
- US-A1- 2001 028 919
- US-A1- 2001 054 598
- US-A1- 2004 262 146

## Beschreibung

Die Erfindung betrifft ein Verfahren zum substratschonenden Entfernen von Hartstoffschichten von einem Substrat, insbesondere von Kohlenstoffschichten von Werkzeugoberflächen, bei dem das zu entschichtende Substrat auf einen Substrathalter in einer Vakuumkammer zwischen zwei Wandantennen angeordnet wird, die Vakuumkammer mit einem den Abtransport von Kohlenstoff in Gasform unterstützenden Reaktionsgas beschickt wird, an die beiden Wandantennen und ggf. den Substrathalter eine gepulste Spannung angelegt wird, wodurch ein Plasma in der Vakuumkammer erzeugt wird, und das Substrat mit dem Plasma über eine hinreichend lange Zeit beaufschlagt wird.

Die Erfindung betrifft des Weiteren eine Vorrichtung zur Durchführung des genannten Verfahrens, mit einer Vakuumkammer, zwei Wandantennen, einem Vakuumanschluss, einem Gaseinlass für ein oder mehrere Reaktionsgase, und Einrichtungen zur Steuerung des Betriebs.

Werkzeugoberflächen werden vielfach mit Diamantschichten oder sog. DLC-Schichten vergütet, um sie hart, reibungsarm und korrosionsfest auszurüsten. Nach längerem Gebrauch ist es unerlässlich, solcher Art behandelte Werkzeuge neu zu beschichten. Bevor eine neue Kohlenstoffschicht aufgebracht werden kann, ist es notwendig, bestehende Schichten zu entfernen. Dies muss auf eine Art und Weise erfolgen, dass das Werkzeugmaterial selbst nicht beschädigt wird.

Bekannt geworden sind nasschemische Verfahren, die aber das Vorhandensein einer metallischen Zwischenschicht voraussetzen, beispielsweise aus Cr, CrN, Si, SiN, Ti, Ti-haltigen Materialien oder dergleichen, die das eigentliche Werkzeug schützen. Dies ist aber nicht in allen Fällen gegeben. Wirkt das nasschemische Verfahren direkt auf das Werkzeug ein, was sich bei einer vollständigen Entfernung der Kohlenstoffschicht nicht vermeiden lässt, kommt es zu Korrosionserscheinungen.

Die Reinigung von Substratoberflächen mit Hilfe von Plasmaverfahren ist vielfach beschrieben. So ist in DE 103 11 552 A1 ein Verfahren zur Reinigung von Werkstücken beschrieben, bei dem Verunreinigungen, wie Kühl- und Schmierstoffe mit Sauerstoff in einem Plasma "abgebrannt" werden. Das Plasmareinigungsverfahren dient hier als Ergänzung einer Ultraschallreinigung.

Aus WO 98/06 885 A1 ist ein Verfahren zum Entfernen von Hartkohlenstofffilmen aus den inneren Oberflächen von Führungsbuchsen bekannt, bei dem in das Innere der Führungsbuchse eine Hilfselektrode eingebracht ist. Soweit dort ein gepulstes Plasma zum Einsatz kommt, wird mit einer RF-Frequenz von 13,56 MHz gearbeitet. In jedem Fall werden Substrat und Wand als Antennen genutzt. Die Antennenanordnung erlaubt keine zuverlässige Steuerung der Plasma- und damit der Substrattemperatur.

EP 0 496 564 A1 beschreibt ebenso das Entfernen einer Hartstoffschicht von einem Substrat mittels eines Plasmaverfahrens, mit den eingangs genannten Verfahrensschritten. Ein ähnliches Verfahren ist in JP 2003-068720 A beschrieben.

Aus US 2001/0028919 A1 ist ein Plasmaverfahren, bei dem das Substrat jedoch nicht auf einem Substrathalter angeordnet wird, der zwischen zwei Wandantennen angeordnet ist. Folglich wird auch nicht eine gepulste Spannung an die beiden Wandantennen und ggf. an den Substrathalter angelegt, um ein Plasma zu erzeugen. Dasselbe gilt für das in US 5,993,680 A behandelte Plasmaverfahren.

Bestimmte Einsatz- und Werkzeugstähle sind ausgesprochen temperaturempfindlich und verändern häufig schon bei Temperaturen von unter 250°C ihre Oberflächenstruktur. Spezialstähle haben teilweise Anlasstemperaturen von ≤ 170°C. Während die oben beschriebenen Ätzverfahren die Oberflächenstruktur und Zusammensetzung negativ beeinflussen, kommt es bei Überschreitung der Temperaturgrenzen zu Gefügeveränderungen, die sich nachteilig auf die Festigkeit auswirken. Benötigt wird deshalb ein Entschichtungsverfahren, das dem Rechnung trägt.

Insbesondere wäre ein Verfahren wünschenswert, das es erlaubt, Schichten bei niedriger Temperatur in den gasförmigen Zustand zu überführen und abzutransportieren. Wünschenswert wäre es ferner, häufig benutzte Zwischenschichten, etwa aus Chrom oder Chromnitrid, in einem Arbeitsgang ebenfalls abzulösen. Schließlich besteht ein Interesse an einem effizienten Verfahren zur Entfernung von Metallschichten und -überzügen, die Kohlenstoff und/oder Stickstoff gebunden enthalten (Carbide/Nitride).

Eine solche schonende Entschichtung wurde jetzt überraschend in der Anwendung eines Niederfrequenzplasmas gefunden.

Die Erfindung betrifft entsprechend ein Entschichtungsverfahren, bei dem Hartstoffschichten von einem Substrat, insbesondere von Kohlenstoffschichten von Werkzeugoberflächen, entfernt werden, das bei einer Temperatur von weniger als 250°C und einem Druck von 1 bis 10⁻³ mbar durchgeführt wird, und bei dem an die Wandantennen und ggf. der Substrathalter mit einem NF-Generator eine gepulste Spannung von 250 bis 1000 V bei 20 bis 60 kHz angelegt wird.

Mit dem erfindungsgemäßen Verfahren können Kohlenstoffschichten jeglicher Art entfernt werden, neben amorphem Kohlenstoff und Graphit auch Diamant. Hierzu gehören insbesondere auch sog. DLC-Schichten mit wechselndem bis hohem Anteil an sp³-hybridisiertem Kohlenstoff. Dabei kann die Temperatur unter einem Grenzwert von 170°C gehalten werden. Die Einhaltung dieses Grenzwertes gewährleistet, dass auch empfindliche Werkstoffe durch das Entschichtungsverfahren nicht beeinträchtigt werden.

Das erfindungsgemäße Verfahren erlaubt es ferner, Hartbeschichtungen, etwa solche, die aus Übergangsmetallcarbiden und/oder -nitriden bestehen, von einem Substrat, das aus einem empfindlichen Werkstoff besteht, zu entfernen. Im Allgemeinen können hierbei die Temperaturen unterhalb 250°C gehalten werden, bei schonender Einstellung des Plasmas und längeren Verfahrenszeiten auch unter 170°C. Es versteht sich, dass bei Vorhandensein unterschiedlicher Schichten jede Schicht das für die Entschichtung am besten geeignete Reaktionsgas zum Einsatz kommt.

Das erfindungsgemäße Verfahren arbeitet mit einem NF-Generator mit einer Pulsfrequenz im Bereich von 20 bis 60 kHz. Beste Abtragungswerte werden mit einer Pulsfrequenz im Bereich von 30 bis 50 kHz insbesondere bei 30 bis 40 kHz erreicht.

Die Arbeitsspannung liegt im Bereich bis zu 1000 V, wobei naturgemäß mit höherer Spannung auch die Leistung und dadurch die Temperatur zunimmt. Im bipolaren Betrieb kann aber selbst bei einer Arbeitsspannung von 1000 V und einer Pulsfrequenz von etwa 40 kHz die Substrattemperatur zuverlässig unter 150°C gehalten werden. Dies erlaubt beispielsweise auch die Entschichtung von Kunststoffsubstraten bzw. von Kunststoff enthaltenden Substraten.

Erfindungsgemäß wird die Entschichtung des Substrats in Gegenwart eines mit Kohlenstoff reaktiven Gases durchgeführt. Als solche reaktiven Gase kommen insbesondere Sauerstoff und sauerstoffhaltige Gase jeglicher Provenienz in Frage. Dies sind beispielsweise Luft und Mischungen aus Sauerstoff mit Edelgasen, Wasserstoff, Wasserdampf, CO₂. In Frage kommen ferner Wasserstoff und wasserstoffhaltige Mischgase, Wasserdampf, Ammoniak, CO₂, CO sowie Mischungen aus Wasserstoff mit Methan, CO₂ und CO. Schließlich können auch Halogene eingesetzt werden, d.h. Fluor, Chlor und insbesondere Jod. Halogene können auch in Form von weniger korrosiven Halogenverbindungen eingesetzt werden, insbesondere mit Stickstoff und Kohlenstoff, etwa als NF₃, CF₄, C₂F₆, aber auch in Form teil- und mischhalogenierter Kohlenwasserstoffe, wie CH₂F₂, CCl₂F₂, CHFCl₂, R 134 a und dergleichen. Pseudohalogenverbindungen kommen ebenfalls in Frage, etwa HCN, (CN)₂, ebenso Stickoxide, etwa N₂O und NO. Weiterhin können Kohlenwasserstoffe als Reaktionsgase eingesetzt werden, etwa CH₄, C₂H₆, C₃H₉ und dergleichen. Die Reaktionsgase haben unter den in der Vakuumkammer herrschenden Bedingungen einen für den gewünschten Zweck ausreichenden Dampfdruck.

Das erfindungsgemäße Verfahren wird unter einem Druck im Bereich von 1 bis 10⁻³ mbar durchgeführt, insbesondere bei einem Druck von 1 bis 0,01 mbar. Unter Druck wird der Druck des Reaktionsgases verstanden. Der Druck kann mit einer handelsüblichen Vakuumpumpe erzeugt werden, die eine hinreichende Kapazität auch zum Abtransport der Reaktionsgase aus der Entschichtung zur Verfügung stellen muss. Eine Pumpleistung von 25 m³/h ist beispielsweise ausreichend.

Der NF-Generator kann auf beliebige Art und Weise betrieben werden, d.h. im bipolaren, im unipolaren und im DC-Betrieb. Bevorzugt sind der bipolare und der DC-Betrieb. Der alternierende Betrieb ist ebenfalls möglich, etwa im bipolaren und DC-Betrieb.

Das erfindungsgemäße Verfahren wird dergestalt durchgeführt, dass das Substrat auf einem Substrathalter zwischen zwei Wandantennen positioniert wird. Vorzugsweise wird das Plasma zwischen den Wandantennen erzeugt, wobei an den Substrathalter eine Biasspannung von bis zu 400 V angelegt werden kann. Die Wandantennen können in dieser Variante bipolar als auch gleichgerichtet (DC) geschaltet sein, wobei sich eine Spannung im Bereich von 300 bis 900 V als vorteilhaft herausgestellt hat. Im bipolaren Betrieb liegt die Spannung vorzugsweise bei 600 bis 900 V, im DC-Betrieb bei 500 bis 800 V.

Alternativ dazu kann der Substrathalter als weitere Antenne benutzt werden. In diesem Fall legt sich das Plasma um das Substrat und bewirkt eine besonders effektive Entschichtung, häufig unter Beobachtung des sog. Krepp-Papier-Effekts, bei dem die Beschichtung zumindest teilweise abblättert. Allerdings steigt bei dieser Betriebsweise die Temperatur schnell auf über 200°C, insbesondere im DC-Betrieb bei einer Spannung von mehr als 700 V. Im bipolaren Betrieb kann die Temperatur dagegen auch bei Arbeitsspannungen von bis zu 700 V unter den kritischen Wert von 170°C gehalten werden.

Im Allgemeinen zeigt sich, dass ein bipolares Plasma wie auch die Verwendung von nur zwei Wandantennen die schonendste Substratbehandlung erlaubt. Der DC-Betrieb führt gegenüber dem bipolaren Betrieb schnell zu erhöhten Temperaturen, der unipolare Betreib des NF-Generators zu weiterer Erhöhung der Substrattemperatur. Auch die Verwendung des Substrathalters als Antenne führt nicht zu einer Verbesserung des Temperaturregimes, dagegen bei Begrenzung der Arbeitsspannung zu einer recht effektiven Ablösung. Der DC-Betrieb und/oder die Verwendung des Substrathalters als Antenne sind für die Entfernung von Metall- und metallhaltigen Schichten vorteilhaft.

Das erfindungsgemäße Verfahren wird unter Temperierung der Anlage durchgeführt, wobei zweckmäßigerweise eine Wasserkühlung der Kammer und ggf. auch der Tür in Frage kommt. Bei speziellen Anwendungen kommt auch eine Temperierung mit warmem Wasser in Frage, beispielsweise um eine Mindesttemperatur bereitzustellen, die die Kondensatbildung ausschließt.

In vielen Fällen ist es zweckmäßig, nach erfolgter Entschichtung das Substrat noch einmal mit Wasserstoff zu beaufschlagen, um Verfärbungen zu beseitigen. Der Wasserstoff wird dazu beispielsweise mit einem Edelgas gemischt. Eine solche Nachreinigung erfolgt vorzugsweise im DC-Betrieb, wobei eine der Wandantennen und der Substrathalter als Antennen dienen.

Mit dem erfindungsgemäßen Verfahren ist es möglich, herkömmlich DLCbeschichtete Werkzeuge in einer zuträglichen Zeit von beispielsweise 60 min zu entschichten. Eine Nachreinigung kann beispielsweise über 15 min nachgeschaltet werden. Die Entfernung von Diamantschichten nimmt längere Zeit in Anspruch.

Es hat sich auch gezeigt, dass als Zwischenschicht auf ein Werkstück aufgebrachte Schichten mit einem Plasma abgetragen werden können, wobei die vorgenannten Gase in Frage kommen.

Die Erfindung betrifft ferner eine Vorrichtung zur Durchführung des vorstehend beschriebenen Verfahrens, die erfindungsgemäß einen zwischen den Wandantennen angeordneten Substrathalter, einen NF-Generator mit einer Pulsfrequenz von 0 bis 60 kHz und einem Spannungsbereich von 0 bis 1000 V, und eine integrierte Temperierung aufweist.

Die Entschichtungsvorrichtung, wie vorstehend beschrieben, kann bipolar, unipolar und mit einem gleichgerichteten Plasma betrieben werden. Bevorzugt ist der Betrieb im bipolaren Modus, bei dem die Spannung an die beiden Wandantennen angelegt wird und ggf. eine Biasspannung an den Substrathalter. Der Substrathalter ist vorzugsweise ein Drehteller.

Gemäß einer weiteren Variante kann die Spannung zwischen einer oder beiden Wandantennen einerseits und dem Substrathalter andererseits aufgebaut werden. Letztere Antennenordnungen sind insbesondere für den DC-Betrieb geeignet.

Unter "Wandantennen" wird eine Antennenanordnung verstanden, bei der zwei flächige Antennen gegenüberliegenden Wänden der Vakuumkammer vorgeschaltet sind. Die Wandantennen können beliebige geometrische Formen haben, d.h. eben ausgebildet sein, gewölbt sein, über Eck ausgebildet sein oder auch halbkugelig. Ziel ist es, ein auf das Substrat auf dem Substratteller ausgerichtetes Plasma bereitzustellen, wozu insbesondere auch eine in Bezug auf das Substrat gewölbte oder gewinkelte Ausführung vorteilhaft ist. In der Regel stehen sich die beiden Wandantennen spiegelsymmetrisch gegenüber.

Die erfindungsgemäße Vorrichtung weist naturgemäß die für die Temperaturüberwachung des Substrats, der Kammerwände und der Kühleinrichtung notwendigen Thermofühler auf.

Die in die Vorrichtung integrierte Temperierung ist in der Regel eine Kühlung, die die Wände und vorzugsweise auch die Tür erfasst. Für bestimmte Anwendungen kann es allerdings sinnvoll sein, eine Vorwärmung vorzusehen, beispielsweise eine gegenüber Raumtemperatur erhöhte Temperatur, um die Entschichtung zu beeinflussen.

Insbesondere für Verfahrensweisen, bei denen kondensierbare Produkte entstehen, kann es sinnvoll sein, einen Kühlfinger, eine Kühlfalle und/oder eine Rohrfalle zur Abscheidung der Reaktionsprodukte vorzusehen. Insbesondere bei der Entschichtung von Substraten, die eine metallische Hartschicht aufweisen, kann eine Heizwendel sinnvoll sein, bei der beispielsweise gebildete Metalljodide zersetzt werden und das Jod in den Entschichtungsprozess zurückkehrt.

Die Erfindung wird durch die beiliegenden Abbildungen näher erläutert. Es zeigen
- Fig. 1:: eine erste Antennenanordnung, die für den unipolaren, bipolaren und DC-Betrieb geeignet ist;
- Fig. 2:: eine Antennenanordnung, bei der der Drehteller mit einer Biasspannung belegbar ist;
- Fig.3:: die Plasmaleistung der verschiedenen Betriebsarten in Abhängigkeit von der Plasmaspannung;
- Fig. 4:: einen Vergleich der Abtragrate bei verschiedenen Pulsfrequenzen;
- Fig. 5:: die Prozesstemperatur in Abhängigkeit von der Plasmaspannung für verschiedene Betriebsweisen und
- Fig. 6:: verschiedene Varianten von für den Einsatz geeigneten Wandantennen.

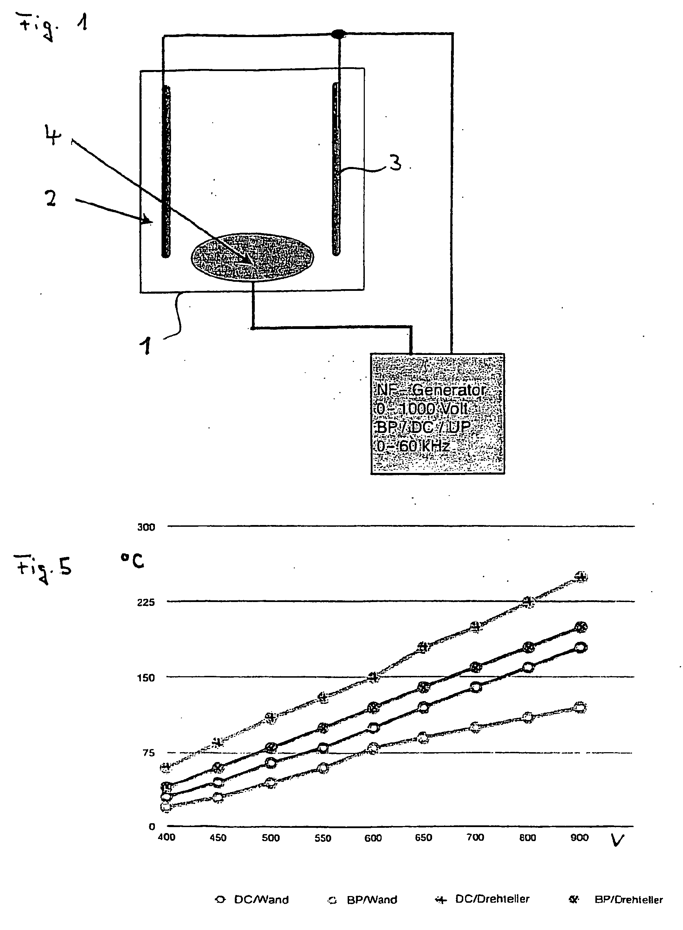

Fig. 1 zeigt in einer Prinzipskizze verschiedene Antennenschaltungen in einer Vakuumkammer 1 mit zwei Wandantennen 2 und 3 sowie einem Drehteller 4 als Substrathalter. Die Vorrichtung wird mit einem NF-Generator betrieben, dessen Spannung stufenlos auf Werte zwischen 0 und 1000 V bei einer Pulsfrequenz von 0 bis 60 kHz einstellbar ist. In der dargestellten Schaltung liegt die Spannung einerseits an den beiden Wandantennen 2 und 3 an und andererseits an dem Drehteller 4. Die Anordnung ermöglicht den bipolaren, unipolaren und DC-Betrieb. Bei der bipolaren Betriebsweise brennt der Glimmsaum auf beiden Wandantennen und am Drehteller 4 bzw. am Substrat, das auf dem Drehteller chargiert ist. Bei der unipolaren oder DC-Betriebsweise brennt der Glimmsaum an den Wandantennen 2 und 3 oder am Drehteller 4, je nach Wahl des Pluspols. In allen Fällen wird das Plasma zwischen den Wandantennen 2 und 3 und dem Drehteller 4 mit dem Substrat erzeugt.

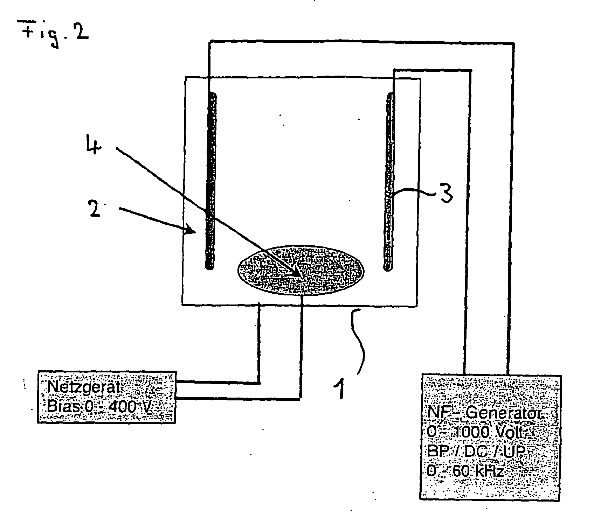

Die Schaltungsanordnung gemäß Fig. 2 zeigt eine Variante, bei der der NF-Generator an den beiden Wandantennen 2 und 3 anliegt. Der Drehteller 4 kann mit einer Biasspannung in Bereich von 0 bis 400 V belegt werden. Auch hier ist eine bipolare, unipolare oder DC-Betriebsweise möglich. Bei der bipolaren Betriebsweise brennt der Glimmsaum auf beiden Wandantennen, bei der unipolaren und DC-Betriebsweise jeweils an der linken oder rechten Wandantenne, je nach Wahl des Pluspols.

Wird an den Substrathalter eine Biasspannung angelegt, wird durch die Bias das erzeugte Plasma angezogen. Die Biasspannung ermöglicht somit eine Modifizierung/Anpassung des Plasmas.

Im Allgemeinen hat sich gezeigt, dass eine Betriebsweise, bei der der NF-Generator an den beiden Wandantennen anliegt, und eine bipolare Spannung angelegt wird, die für die Entschichtung von Substraten günstigste Verfahrensweise ist. Hier wird die Entschichtung bei der geringsten Temperaturbelastung erreicht. Eine Erklärung hierfür ist, dass durch den Spannungswechsel die Beaufschlagung des Substrats mit reaktive Ionen immer wieder unterbrochen wird, was zum einen den Abtransport des Kohlenstoffs über die Gasphase begünstigt und zum anderen einen Temperaturstau an der Oberfläche vermeidet. Das pulsierende Plasma gibt somit der Oberfläche des Substrats die Möglichkeit, sich immer wieder kurzfristig "zu erholen".

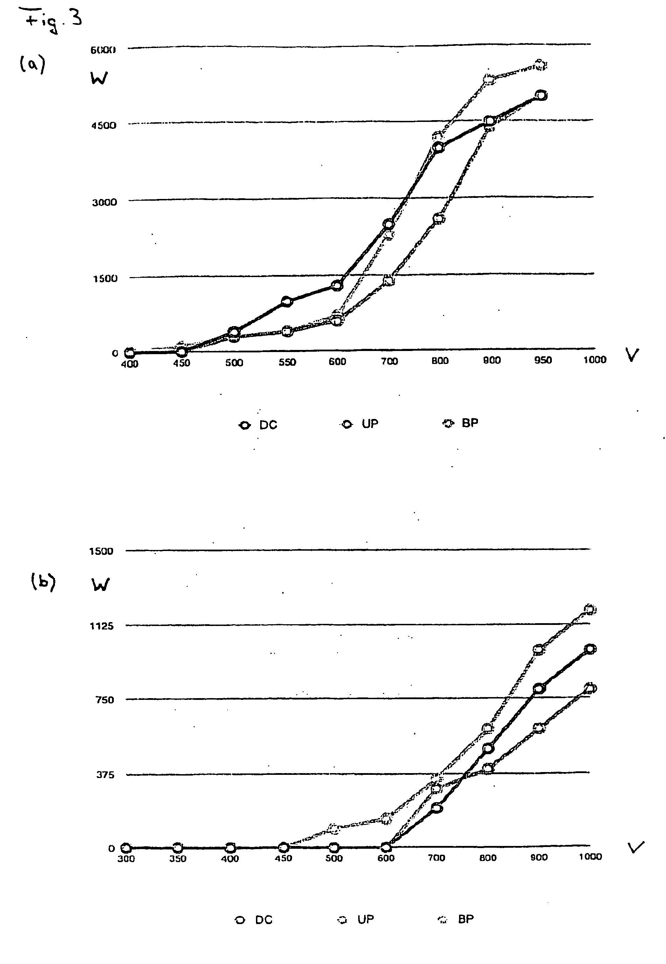

Die in Fig. 3 dargestellten Kurven zeigen die Plasmaleistung bei einem Druck von 2,5 x 10⁻¹ mbar (a) und 5,0 x 10⁻² mbar (b). Dargestellt ist die Leistung bei einer Plasmaspannung von 400 bis 1000 V bei einer Pulsfrequenz von 40 kHz, wobei der NF-Generator auf die beiden Wandantennen geschaltet ist. Es ergibt sich bei höheren Spannungen ab etwa 800 V (a) bzw. 450 V (b) ein deutlicher Vorteil für den bipolaren Betrieb, d.h. der bipolare Betrieb ergibt gegenüber dem unipolaren oder DC-Betrieb bei der Arbeitsspannung eine höhere Plasmaleistung am Substrat.

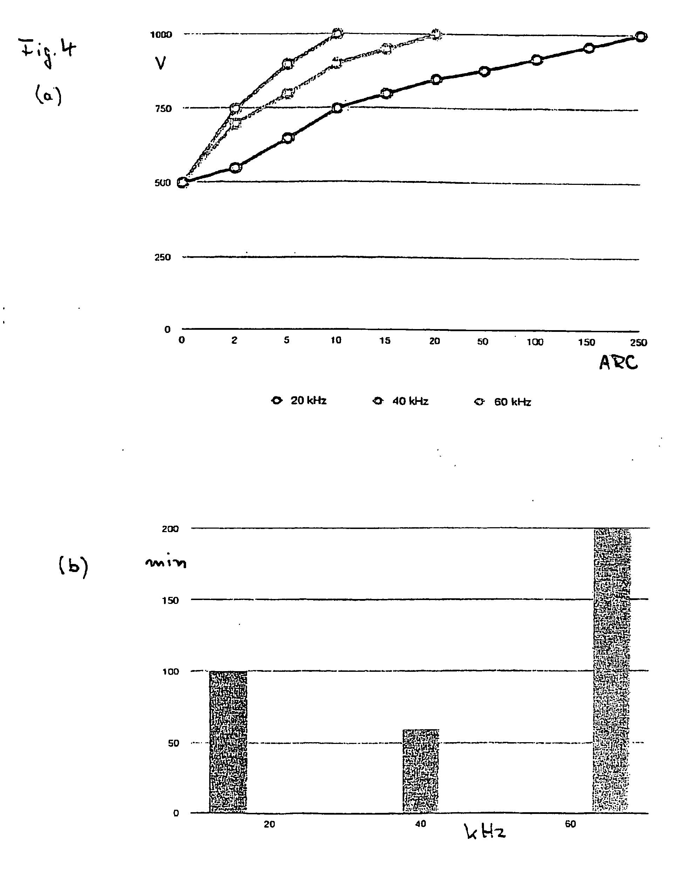

Fig. 4(a) zeigt die Abtragungsrate in einem Bereich von 500 bis 1000 V für mit 20, 40 und 60 kHz gepulste Plasmen. Die Vorrichtung wird dabei über die Wandantennen im DC-Betrieb gefahren. Es ergibt sich eine optimale Abtragungsrate für eine Pulsfrequenz von 40 kHz, gegenüber 20 und 60 kHz. Fig. 4 (b) zeigt für ein standardisiertes Substrat die Entschichtungszeit bei einem Druck von 2,5 x 10⁻¹ mbar und einer Arbeitsspannung von 600 V für Pulsfrequenzen von 20, 40 und 60 kHz. Die Anlage wird, wie in Fig. 4(a) im DC-Betrieb über die Wandantennen gefahren. Die Entschichtungszeit ist für den Betrieb bei 40 kHz mit 60 min deutlich geringer als bei 20 kHz mit 100 min und 60 kHz bei 200 min.

Fig. 5 zeigt die Prozesstemperatur in Abhängigkeit von der Plasmaspannung in Volt für den bipolaren und den DC-Betrieb, wobei das Plasma entweder zwischen den Wandantennen erzeugt wird oder aber zwischen den Wandantennen einerseits und dem Drehteller andererseits. Die Anlage wurde bei einem Druck von 2,5 x 10⁻¹ mbar gefahren, die Pulsfrequenz betrug 40 kHz.

Ein sehr guter Temperaturverlauf ergibt sich bei bipolarer Arbeitsweise, bei der das Plasma zwischen den Wandantennen allein erzeugt wird. Selbst bei einer Arbeitsspannung von 900 V bleiben die Temperaturen unter einem oberen Wert von 120°C. Im DC-Betrieb ergibt die gleiche Spannungsanordnung einen oberen Temperaturwert von etwa 175°C bei 900 V.

Wird das Plasma zwischen den Wandantennen einerseits und dem Drehteller andererseits erzeugt, ergibt sich für den bipolaren Betrieb eine maximale Temperatur bei 900 V von 200°C, bei DC-Betrieb von mehr als 250°C.

Bei unipolarem Betrieb werden jeweils noch höhere Prozesstemperaturen erreicht.

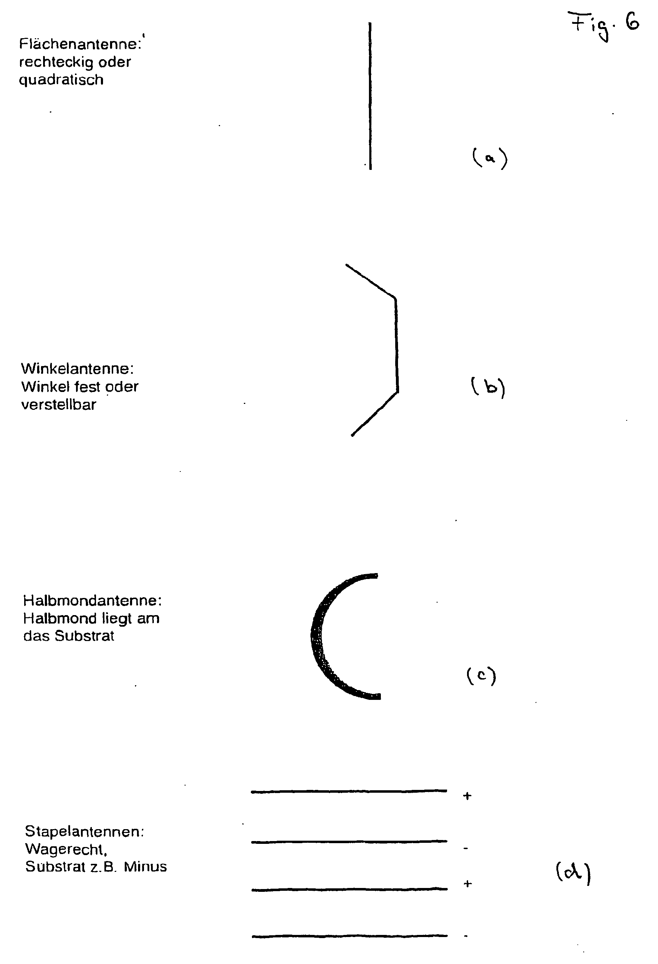

Fig. 6 zeigt verschiedene Varianten von geeigneten Wandantennen. In jedem Fall sind diese Wandantennen so angeordnet, dass der Substratteller mit dem darauf angeordneten Substrat dazwischen zu liegen kommt. Die einfachste Form (a) sind zwei Flächenantennen, die rechteckig oder quadratisch an gegenüberliegenden Wänden der Kammer angeordnet sind. Die Variante (b) zeigt eine gewinkelte Antennenanordnung, die Substratteller mit Substrat von beiden Seiten mehr oder weniger umgibt. Die Flügel der Antenne können fest oder verstellbar sein. (c) zeigt eine halbkreisförmige Antenne, die sich um das Substrat erstreckt. Variante (d) zeigt eine sog. Stapelantenne, die beispielsweise aus Gitterrosten besteht. Das Substrat wird auf einem oder mehreren dieser Roste angeordnet, wobei es sich vorzugsweise um Kleinteile oder Schüttgut handelt. Das Plasma bildet sich zwischen Gittern gegensätzlicher Polarität aus.

Die nachfolgenden Ausführungsbeispiele dienen der weiteren Erläuterung der Erfindung.

Beispiel 1: Für die Entschichtung von DLC-beschichteten Stählen, mit einer Schichtdicke der C-Phase von etwa 2 µm, mit Anlasstemperaturen von 180°C und weniger wurde das Werkstück in einer Vakuumkammer mit gegenüberliegenden Wandantennen auf einem Drehteller bei einem Arbeitsdruck von 5,0 x 10⁻¹ mbar mit einem bipolar angeregten Plasma beaufschlagt. Die Plasmaspannung wurde auf 700 V festgelegt, bei einer Pulsfrequenz von 40 kHz. Das Werkstück wurde in weniger als 60 min von anhaftenden kohlenstoffhaltigen Schichten befreit. Die Temperatur des Wertstücks blieb unter 100°C.

Für die Entschichtung von bei niedrigen Temperaturen angelassenen Stählen empfiehlt sich im Allgemeinen eine Plasmaspannung von 600 bis 900 V bei Verwendung einer bipolaren Plasmaanregung, und von 500 bis 800 V bei DC-Anregung. Als Prozessgase kommen neben Sauerstoff noch Luft und sauerstoffhaltige Mischgase in Frage.

Beispiel 2: Ein DLC-beschichteter Stahl mit einer Anlasstemperatur von weniger als 300°C wurde in einer Vakuumkammer auf einem Drehteller zwischen zwei Wandantennen bei einem Arbeitsdruck von 5,0 x 10⁻¹ mbar mit Sauerstoff als Reaktionsgas behandelt. Die Plasmaspannung betrug 700 V bei 40 kHz. Die Entschichtung erfolgt im DC-Betrieb bei Temperaturen um 140°C.

Bei Entschichtungen mit DC-Anregung kommen im Allgemeinen Plasmaspannungen von 500 V bis 800 V in Frage. Die bevorzugten Prozessgase entsprechen denen von Beispiel 1.

Anstelle des in den Beispielen 1 und 2 verwandten Arbeitsdrucks kann auch ein niedrigerer Arbeitsdruck verwandt werden, von etwa 2,5 x 10⁻¹ mbar. Die Pulsfrequenz ist insbesondere 40 kHz, kann aber auf einen Wert bis hin zu 30 kHz abgesenkt werden, ohne dass sich wesentliche Änderungen für das Verfahren ergeben.

Im Allgemeinen werden DLC-beschichtete Vorrichtungen mit einer Schichtdicke von bis zu 50 µm in etwa 60 min komplett entschichtet. Bei extrem dick beschichteten Werkstücken (100 µm) bedarf es mehrer Stunden, wobei das anstehende Plasma die Schichten auch teilweise abplatzen lässt.

Für kohlenstoffhaltige Beschichtungen aus Me:C und WC:C werden einige Stunden benötigt. Auch diese Schichten können komplett entfernt werden.

Beispiel 3: Zur Entfernung von braunen Verfärbungen der Werkstücke nach der Entschichtungsbehandlung kann das Werkstück bei einem gleich bleibenden Arbeitsdruck anschließend direkt mit einem Wasserstoffplasma weiter gereinigt werden. Verwandt werden Mischungen aus Wasserstoff mit inerten Gasen, beispielsweise Argon, etwa eine Mischung Argon/Wasserstoff im Verhältnis 2/1.

Für die Wasserstoffbehandlung wird ein DC-Plasma mit einer Spannung von 400 V bei 36 kHz verwandt. Die Spannung wird an eine der beiden Wandantennen und den Drehteller angelegt. Behandlungsdauer bis zur vollständigen Entfärbung ist etwa 15 min.

Beispiel 4: Versuche zur Entschichtung von Kohlenstoff, bei dem sich CO₂ als Abfallprodukt bildet, zeigen, dass sich bei bestimmten Druckverhältnissen und Plasmaanregungen auch eine CrN-Schicht anätzen lässt. Bei bipolarer Schaltung einer Wandantenne und des Drehtellers und den in Beispiel 1 genannten Bedingungen konnte mit CO als Reaktionsgas bei einem Arbeitsdruck von 2,5 x 10⁻¹ mbar eine Chromnitridschicht in einem mehreren Stunden anhaltenden Prozess entfernt werden. Entschichtungsdauern von 12 Stunden können hierzu erforderlich sein, je nach Schichtdicke.

Beispiel 5: Verschiedene Hartmetall-Fräser mit Diamant-Beschichtungen unterschiedlicher Hersteller wurden in einer Vakuumanlage mit einer Wandantennenschaltung im DC-Betrieb bei einer Anregungsfrequenz von 40 kHz und einer Plasmaspannung von 800 V behandelt. Der Arbeitsdruck betrug 5×10⁻¹ bar, die Kammer wurde unter 250°C gehalten.

Mit Sauerstoff als Reaktivgas wurden die Fräser in einer Zeit von 14 bis 20 h entschichtet, je nach Herkunft.

Beispiel 6: Ein HSS-Spiralbohrer mit einer 2 µm starken TiN-Beschichtung wurde in einer Vakuum-Anlage mit einer Wandantennenschaltung im DC-Betrieb mit Jod behandelt. Die Anregungsfrequenz betrug 40 kHz, die Plasmaspannung 400 V, der Arbeitsdruck 5 x 10⁻¹ mbar und die Kammertemperatur etwa 120°C.

Zur Versorgung mit Jod wurden 50 g Jod als Festsubstanz in einem Glastiegel vorgelegt, welches unter dem Arbeitsdruck langsam verdampfte. Damit das Gas nicht aus der Kammer abgezogen wurde, wurde die Vakuumpumpe nach Erreichen des Arbeitsdrucks abgeschaltet und erst nach Beendigung des Prozesses wieder zugeschaltet.

Nach 4 h war der Spiralbohrer von der Hartstoffschicht entschichtet.

Beispiel 7: Ein HSS-Spiralbohrer mit einer 2 µm starken TiN-Beschichtung wurde in einer Vakuumkammer mit NF₃ entschichtet. Die Wandantennen waren gegen den Substrathalter als Antenne im DC-Betrieb geschaltet. Die Anregungsfrequenz betrug 40 kHz, die Plasmaspannung 600 V, der Arbeitsdruck 5 x 10⁻¹ mbar und die Kammertemperatur etwa 150°C. Nach 2,5 h war die TiN-Schicht rückstandslos entfernt. - Patentansprüche -

## Patentansprüche

1. Verfahren zum substratschonenden Entfernen von Hartstoffschichten von einem Substrat, insbesondere von Kohlenstoffschichten von Werkzeugoberftächen, bei dem
- das zu entschichtende Substrat auf einen Substrathalter in einer Vakuumkammer (1) zwischen zwei Wandantennen (2, 3) angeordnet wird,
- die Vakuumkammer (1) mit einem den Abtransport von Kohlenstoff in Gasform unterstützenden Reaktionsgas beschickt wird,
- an die beiden Wandantennen (2, 3) und ggf. den Substrathalter eine gepulste Spannung angelegt wird, wodurch ein Plasma in der Vakuumkammer (1) erzeugt wird, und
- das Substrat mit dem Plasma über eine hinreichend lange Zeit beaufschlagt wird,
**dadurch gekennzeichnet, dass**
- das Verfahren bei einer Temperatur von weniger als 250°C und einem Druck von 1 bis 10⁻³ mbar durchgeführt wird, und
- an die Wandantennen (2, 3) und ggf. der Substrathalter mit einem NF-Generator eine gepulste Spannung von 250 bis 1000 V bei 20 bis 60 kHz angelegt wird.

2. Verfahren nach Anspruch 1, **gekennzeichnet durch** einen bipolaren Betrieb der Antennenordnung.

3. Verfahren nach Anspruch 2, **dadurch gekennzeichnet, dass** die bipolare Spannung nur an die Wandantennen (2, 3) angelegt wird.

4. Verfahren nach Anspruch 3, **dadurch gekennzeichnet, dass** an den Substrathalter eine Biasspannung von ≤ 400 V angelegt wird.

5. Verfahren nach Anspruch 1, **gekennzeichnet durch** eine gepulste Gleichspannung (DC-Betrieb).

6. Verfahren nach Anspruch 5, **dadurch gekennzeichnet, dass** die gepulste Gleichspannung an die Wandantennen (2, 3) angelegt wird.

7. Verfahren nach Anspruch 5, **dadurch gekennzeichnet, dass** die gepulste Gleichspannung zwischen den Wandantennen (2, 3) und dem Substrathalter angelegt wird.

8. Verfahren nach einem der vorstehenden Ansprüche, **dadurch gekennzeichnet, dass** das Verfahren unter Kühlung durchgeführt wird.

9. Verfahren nach einem der vorstehenden Ansprüche, **gekennzeichnet durch** eine Pulsfrequenz von 30 bis 40 kHz.

10. Verfahren nach einem der vorstehenden Ansprüche, **dadurch gekennzeichnet, dass** als Reaktionsgas Sauerstoff, sauerstoffhaltige Mischgase, Wasserstoff, wasserstoffhaltige Mischgase, Wasserdampf, Ammoniak, Methan, CO₂, CO, Halogene, Halogenverbindungen, HCN oder (CN)₂ verwandt wird.

11. Verfahren nach einem der vorstehenden Ansprüche, **dadurch gekennzeichnet, dass** ein Reinigungsschritt unter Verwendung von Wasserstoff als Reaktionsgas nachgeschaltet wird.

12. Vorrichtung zur Durchführung des Verfahrens nach einem der vorstehenden Ansprüche mit einer Vakuumkammer (1), zwei Wandantennen (2, 3), einem Vakuumanschluss, einem Gaseinlass für ein oder mehrere Reaktionsgase, und Einrichtungen zur Steuerung des Betriebs, **gekennzeichnet durch** einen zwischen den Wandantennen (2, 3) angeordneten Substrathalter, einen NF-Generator mit einer Pulsfrequenz von 0 bis 60 kHz und einem Spannungsbereich von 0 bis 1000 V, und eine integrierte Temperierung.

13. Vorrichtung nach Anspruch 12, **dadurch gekennzeichnet, dass** die Wandantennen (2, 3) spiegelsymmetrisch so zueinander angeordnet sind, dass sie den Substrathalter umgeben.

14. Vorrichtung nach Anspruch 12 oder 13, **dadurch gekennzeichnet, dass** der Substrathalter ein Drehteller (4) ist.

15. Vorrichtung nach einem der Ansprüche 13 oder 14, **dadurch gekennzeichnet, dass** der Substrathalter mit einer Biasspannung belegbar ist.

16. Vorrichtung nach einem der Ansprüche 12 bis 15, **dadurch gekennzeichnet, dass** die integrierte Temperierung eine in die Wände und die Tür integrierte Wasserkühlung ist.

17. Vorrichtung nach einem der Ansprüche 12 bis 16, **gekennzeichnet durch** einen Kühlfinger, eine Kühlfalle und/oder eine Rohrfalle zur Abscheidung von kondensierbaren Reaktionsprodukten.

18. Verwendung des Verfahrens nach einem der Ansprüche 1 bis 11 und der Vorrichtung nach einem der Ansprüche 12 bis 17 zum Entfernen von metallischen Hartschichten von Substraten.

## Claims

1. A method for the substrate-protective removal of hard coatings from a substrate, particularly of carbon coatings from tall surfaces, in which:
- the substrate from which the coating is to be removed is disposed on a substrate holder in a vacuum chamber (1) between two wall antennas (2, 3),
- the vacuum chamber (1) is filled with a reaction gas assisting the removal of carbon in gaseous form,
- a pulsed voltage is applied to the two wall antennas (2, 3) and optionally to the substrate holder, whereby a plasma is produced in the vacuum chamber (1),
- the substrate is acted on by the plasma for a sufficiently long period of time,
- **characterised in that** the method is performed a temperature of less than 250°C and a pressure of 1 to 10⁻³ mbar, and
- a pulsed voltage of 250 to 1000 V at 20 to 60 kHz is applied to the wall antennas (2, 3) and optionally the substrate holder with a low frequency generator,

2. A method as claimed in claim 1, **characterised by** bipolar operation of the antenna assembly.

3. A method as claimed in claim 2, **characterised in that** the bipolar voltage is applied only to the wall antennas (2, 3).

4. A method as claimed in claim 3, **characterised in that** a bias voltage of ≤ 400V is applied to the substrate holder.

5. A method as claimed in claim 1, **characterised by** a pulsed direct current voltage (DC Operation).

6. A method as claimed in claim 5, **characterised in that** the pulsed direct current voltage is applied to the wall antennas (2, 3).

7. A method as claimed in claim 5, **characterised in that** the pulsed direct current voltage is applied between the wall antennas (2, 3) and the substrate holder.

8. A method as claimed in one of the preceding claims, **characterised in that** the method is performed with cooling.

9. A method as claimed in one of the preceding claims, **characterised by** a pulse frequency of 30 to 40 kHz.

10. A method as claimed in one of the preceding claims, **characterised in that** oxygen, oxgen-containing mixed gases, hydrogen, hydrogen-containing mixed gases, water vapour, ammonia, methane, CO₂, CO, halogens, halogen compounds, HCN or (CN)₂ is used as the reaction gas.

11. A method as claimed in one of the preceding claims, **characterised in that** a cleaning step is subsequently effected using hydrogen as the reaction gas.

12. Apparatus for carrying out the method as claimed in one of the preceding claims with a vacuum chamber (1), two wall antennas (2, 3) a vacuum connection, a gas inlet for one or more reaction gases and devices for controlling the operation, **characterised by** a substrate holder arranged between the wall antennas (2, 3) a low frequency generator with a pulse frequency of 0-60 kHz and a voltage range of 0 to 1000 V and an integrated cooler.

13. Apparatus as claimed in claim 12, **characterised in that** the wall antennas (2, 3) are arranged mirror symmetrically with respect to one another so that they surround the substrate holder.

14. Apparatus as claimed in claim 12 or 13, **characterised in that** the substrate holder is a rotary table (4).

15. Apparatus as claimed in one of claims 13 or 14, **characterised in that** a bias voltage may be applied to the substrate holder.

16. Apparatus as claimed in one of claims 13 to 15, **characterised in that** the integrated cooler is a water cooler integrated into the walls and the door.

17. Apparatus as claimed in one of claims 12 to 16, **characterised by** a cooling finger, a cooling trap and/or a pipe trap for the deposition of condensable reaction products.

18. Use of the method as claimed in one of claims 1 to 11 and the apparatus as claimed in claims 12 to 17 for removing hard metallic coatings from substrates.

## Revendications

1. Procédé pour la suppression de couches de matière solide préservant un substrat, en particulier de couches de carbone de surfaces d'outils, dans lequel
- le substrat duquel on enlève les couches est placé sur un support de substrat dans une chambre à vide (1) entre deux antennes verticales (2, 3),
- la chambre à vide (1) est chargée avec un gaz de réaction aidant au transport pour l'enlèvement du carbone sous forme gazeuse,
- sur les deux antennes verticales (2, 3) et éventuellement le support de substrat est appliquée une tension pulsée, par laquelle un plasma est produit dans la chambre à vide (1), et
- le substrat est soumis à l'action du plasma pendant une durée suffisamment longue,
**caractérisé en ce que**
- le procédé est mis en oeuvre à une température inférieure à 250°C et sous une pression de 1 à 10⁻³ mbar, et
- on applique sur les antennes verticales (2, 3) et éventuellement le support de substrat, avec un générateur à basse fréquence, une tension pulsée de 250 à 1000 V à 20 à 60 kHz.

2. Procédé selon la revendication 1, **caractérisé par** un fonctionnement bipolaire du dispositif d'antenne.

3. Procédé selon la revendication 2, **caractérisé en ce que** la tension bipolaire n'est appliquée qu'aux antennes verticales (2, 3).

4. Procédé selon la revendication 3, **caractérisé en ce que** sur le support de substrat est appliqué une tension de polarisation de ≤ 400 V.

5. Procédé selon la revendication 1, **caractérisé par** une tension continue pulsée (fonctionnement en courant continu).

6. Procédé selon la revendication 5, **caractérisé en ce que** la tension continue pulsée est appliquée sur les antennes verticales (2, 3).

7. procédé selon la revendication 5, **caractérisé en ce que** la tension continue pulsée est appliquée entre les antennes verticales (2, 3) et le support de substrat.

8. Procédé selon l'une des revendications précédentes, **caractérisé en ce que** le procédé est mis en oeuvre sous refroidissement.

9. Procédé selon l'une des revendications précédentes, **caractérisé par** une fréquence d'impulsions de 30 à 40 kHz.

10. Procédé selon l'une des revendications précédentes, **caractérisé en ce qu'**on utilise à titre de gaz de réaction l'oxygène, des gaz mixtes contenant de l'oxygène, l'hydrogène, des gaz mixtes contenant de l'hydrogène, de la vapeur d'eau, de l'ammoniac, du méthane, CO₂, CO, des halogènes, des composés halogénés, HCN ou (CN)₂.

11. Procédé selon l'une des revendications précédentes, **caractérisé en ce qu'**on adjoint une étape de purification avec utilisation de l'hydrogène comme gaz de réaction.

12. Dispositif pour la mise en oeuvre du procédé selon l'une des revendications précédentes, avec une chambre à vide (1), deux antennes verticales (2, 3), un raccordement au vide, une arrivée de gaz pour un ou plusieurs gaz de réaction, et des dispositifs pour commander le fonctionnement, **caractérisé par** un support de substrat disposé entre les antennes verticales (2, 3), un générateur à basses fréquences avec une fréquence d'impulsions de 0 à 60 kHz et un intervalle de tension de 0 à 1000 V, et un réglage de température intégré.

13. Dispositif selon la revendication 12, **caractérisé en ce que** les antennes verticales (2, 3) sont disposées selon une symétrie de réflexion l'une par rapport à l'autre de telle manière qu'elles entourent le support de substrat.

14. Dispositif selon la revendication 12 ou 13, **caractérisé en ce que** le support de substrat est un plateau tournant (4).

15. Dispositif selon l'une des revendications 13 ou 14, **caractérisé en ce que** le support de substrat est apte à être relié à une tension continue.

16. Dispositif selon l'une des revendications 12 à 15, **caractérisé en ce que** le réglage de température intégrée est un refroidissement à l'eau intégré dans les parois et dans la porte.

17. Dispositif selon l'une des revendications 12 à 16, **caractérisé par** un doigt réfrigérant, un piège de refroidissement et/ou un piège tubulaire pour la séparation des produits de réaction condensables.

18. Utilisation du procédé selon l'une des revendications 1 à 11 et du dispositif selon l'une des revendications 12 à 17 pour la séparation de couches dures métalliques de substrats.
